# EUROPEAN PATENT SPECIFICATION

(11) **EP 3 832 378 B1**
(45) Date of publication and mention of the grant of the patent: **13.11.2024**
(21) Application number: 19843914.3
(22) Date of filing: 31.07.2019
(51) Int. Cl.: G02C 7/10, G02B 1/10, G02B 1/12, G02B 1/14

(54) **OPTICAL PRODUCT AND METHOD OF MANUFACTURING THE SAME**
OPTISCHES PRODUKT UND VERFAHREN ZUR HERSTELLUNG DAVON
PRODUIT OPTIQUE ET PROCÉDÉ POUR SA FABRICATION

(30) Priority: 31.07.2018 JP 2018144187
(43) Date of publication of application: 09.06.2021
(73) Proprietor: HOYA LENS THAILAND LTD., Pathumthani 12130 (TH)
(72) Inventor: SUZUKI, Keiichi, Tokyo 160-8347 (JP)
(74) Representative: Kraus & Lederer PartGmbB
(86) International application number: PCT/JP2019/029961
(87) International publication number: WO 2020/027178

(56) References cited:
- WO-A1-2016/159252
- WO-A1-2018/015650
- JP-A- 2012 215 725
- JP-A- H02 223 909
- JP-A- H02 223 909
- JP-U- 3 122 481
- KR-A- 20180 021 637
- US-A1- 2004 257 525
- US-A1- 2014 293 469
- US-A1- 2017 242 164
- ALOV NIKOLAI V ED - BRAUCHER RÉGIS ET AL: "Surface oxidation of metals by oxygen ion bombardment", NUCLEAR INSTRUMENTS & METHODS IN PHYSICS RESEARCH. SECTION B: BEAM INTERACTIONS WITH MATERIALS AND ATOMS, vol. 256, no. 1, 16 January 2007 (2007-01-16), pages 337 - 340, XP029160804, ISSN: 0168-583X, DOI: 10.1016/J.NIMB.2006.12.023

## Description

### [Technical Field]

The present invention relates to a spectacle lens and a method of manufacturing the same.

### [Background Art]

Various optical products such as lenses are generally produced by forming, on the surface of a base material, a functional layer for imparting a desired function to the optical product (see, for example, PTL 1).

### [Citation List]

### [Patent Literature]

[PTL 1] Japanese Patent Application Publication No. 2013-11711

### [Summary of Invention]

### [Technical Problem]

PTL 1 discloses an optical product having a metal layer as a functional layer. As the optical product has a metal layer, transmission and/or reflection of light that is incident on the optical product can be controlled.

Further prior art disclosing a spectacle lens with a metal layer and an passivated layer is JPH02223909A.

Exhibiting little change in physical properties over time is one desirable characteristic of optical products.

One aspect of the present invention provides for a spectacle lens that exhibits little change in physical properties over time.

### [Solution to Problem]

One aspect of the present invention relates to a spectacle lens according to claim 1.

The term "passivation" denotes a state in which a metal undergoes no corrosion although the metal is under conditions of thermodynamical corrosion; the term corrosion denotes a state in which a metal disappears from a surface by being brought to a non-metal state as a result of a chemical reaction. In the above optical product, as the surface layer portion of the metal layer is passivated, changes in physical properties caused by corrosion of the metal layer, in particular, changes in transmittance over time, can be suppressed. This is preferable in an optical product that desirably exhibits a stable transmittance characteristic.

### [Effects of Invention]

According to one aspect of the present invention, a spectacle lens can be provided that has a metal layer on a base material, and that exhibits little change in transmittance over time.

### [Description of Embodiments]

The above optical product and a method of manufacturing the same will be explained below in further detail.

### <Base material>

Various types of base material that are generally utilized in optical products can be used herein as the base material. For example, a plastic base material or glass base material can be used as the base material. The glass base material can be, for example, a base material made of inorganic glass. A plastic base material is preferable as the base material, in terms of being lightweight and hard to break. Examples of the plastic base material include styrene resins including (meth)acrylic resins, polycarbonate resins, allyl resins, allyl carbonate resins such as a diethylene glycol bisallyl carbonate resin (CR-39), vinyl resins, polyester resins, polyether resins, urethane resins obtained through reaction of an isocyanate compound with a hydroxy compound such as diethylene glycol, thiourethane resins obtained through reaction of an isocyanate compound with a polythiol compound, as well as cured products (generally referred to as transparent resins) resulting from curing a curable composition that contains a (thio)epoxy compound having one or more disulfide bonds in the molecule. An untinted material or a tinted material may be used as the base material. Since the optical product is a spectacle lens, the base material (lens base material) may be an untinted lens (so-called colorless lens), or may be a colored lens. The refractive index of the lens base material of the spectacle lens can be, for example, about 1.60 to 1.75. However, the refractive index of the lens base material of the spectacle lens is not limited to the above range, and may lie within the above range, or be offset from the above range to higher or lower values. In the present invention and the present description, the term refractive index denotes refractive index towards light having a wavelength of 500 nm. The lens base material of the spectacle lens may be a lens having refractive power (so-called prescription lens) or a lens without refractive power (so-called non-prescription lens). The spectacle lens can be of various lens types, and, for example, may be a single-focus lens, a multi-focus lens or a progressive lens. The type of the spectacle lens is ordinarily determined by the surface shapes on both sides of the lens base material. The surface of the lens base material of the spectacle lens may be a convex surface, a concave surface or a planar surface. In ordinary lens base materials and spectacle lenses, an object-side surface is a convex surface and an eye-side surface is a concave surface. The present invention is, however, not limited thereto. The term "object-side surface" is the surface positioned on the object side at a time where the wearer is wearing spectacles that are provided with the spectacle lens. The term "eye-side surface" is the surface on the side opposite thereto, i.e. the surface positioned on the eye side at a time where the wearer is wearing spectacles that are provided with the spectacle lens.

### <Metal layer>

The above optical product has a metal layer on the base material. In the present invention and the present description, the term "metal layer" denotes a film formed through deposition, in accordance with an arbitrary film formation method, of a component (hereafter also notated simply as "metal") selected from the group consisting of metal elements as simple substances (pure metals) and alloys of a plurality of metal elements, and is a film consisting of a metal, except for impurities that become inevitably mixed in at the time of film formation and known additives that are used arbitrarily in order to assist film formation. The metal layer can be a film in which a metal takes up, for example, 90 to 100 mass%, and can be a film in which a metal takes up 95 to 100 mass%, of the mass of the film. Examples of the metal element include metal elements that can be brought to a passivated from, for example, chromium group elements (for example chromium (Cr), molybdenum (Mo) and tungsten (W)), iron group elements (for example iron (Fe), cobalt (Co) and nickel (Ni)), transition elements such as niobium (Nb) and titanium (Ti), noble metal elements (for example copper (Cu), silver (Ag) and gold (Au)), and aluminum (Al). Preferred herein are chromium, niobium, titanium and aluminum, and more preferably chromium, for example, from the viewpoint of transmittance, film stability and material availability. The film thickness of the metal layer lies in the range of 15 to 30 nm. The film thickness of the metal layer can be measured in accordance with a known film thickness measurement method. The same applies to the various types of layer described below. The film thickness of the metal layer denotes film thickness including also a passivated surface layer portion.

The metal layer can be formed on the base material in accordance with a known film formation method. Film formation is preferably accomplished by vapor deposition, from the viewpoint of ease of film formation. That is, the metal layer is preferably a vapor-deposition film. The term vapor-deposition film denotes a film formed by vapor deposition. In the present invention and the present description, the term "vapor deposition" encompasses dry methods, for example, vacuum deposition, ion plating and sputtering. In a vacuum deposition method, an ion beam assist method may be utilized in which an ion beam is simultaneously projected during vapor deposition.

A surface layer portion of the metal layer, on the side opposite to that of the base material, is passivated. In the present invention and the present description, the term "surface layer portion" is a region, of the metal layer, at a partial region extending from the surface of the metal layer, on the side opposite to that of the base material, into the interior of the layer. The thickness of the surface layer portion is smaller than the film thickness of the metal layer, and can be, for example, a thickness that is 80% or less, or a thickness that is 70% or less, or a thickness that is 60% or less, or a thickness that is 50% or less, of the film thickness of the metal layer. The thickness of the surface layer portion is smaller than the film thickness of the metal layer, and can be, for example, a thickness of 5% or more, a thickness of 10% or more, a thickness of 15% or more, a thickness of 20% or more, a thickness of 25% or more, or a thickness of 30% or more, of the film thickness of the metal layer. For example, the thickness of the surface layer portion is smaller than the film thickness of the metal layer, and can lie in the range of 1 to 30 nm, preferably in the range of 1 to 10 nm. The thickness of the surface layer portion can be determined on the basis of the treatment conditions of a passivation treatment described in detail below. For example, the penetration depth of oxygen ions that penetrate on account of oxygen ion irradiation can be taken as the thickness of the surface layer portion. Alternatively, the thickness of the surface layer portion can be measured by X-ray photoelectron spectroscopy. Herein X-ray photoelectron spectroscopy is an analysis method referred to as ESCA (Electron Spectroscopy for Chemical Analysis) or XPS (X-ray Photoelectron Spectroscopy). The surface layer portion of the metal layer can be a layer of a metal oxide in which the metal constituting the metal layer is passivated through oxidation, and can be a layer of the metal in which a portion of the metal layer other than the surface layer portion is not passivated by oxidation. For example, a portion in which oxygen atoms are detected, by X-ray photoelectron spectroscopy, at a content ratio of 10 at% or more, can be deemed to be the surface layer portion. Herein the O 1s_1 spectrum is used for oxygen atoms in X-ray photoelectron spectroscopy.

Passivation of the surface layer portion of the metal layer according to the invention is accomplished by an oxidation treatment. The oxidation treatment may be carried out in accordance with any method, so long as oxygen can be introduced into the interior of the metal layer from the surface thereof, on the side opposite to that of the base material. From the viewpoint of oxidation efficiency, the introduced oxygen is preferably in a state of higher activity than that of oxygen molecules, and may be, for example, oxygen ions or oxygen radicals (including oxygen free radicals such as hydroxy radicals and superoxide anions). Specific examples of the oxygen introduction method include irradiation with an ion gun, ion beam irradiation, ion plating, and methods that utilize an RF (Radio Frequency) radical source. Various conditions at the time of oxygen introduction may be set to conditions that allow oxidizing (passivating) a region having a desired thickness, from the surface of the metal layer on the side opposite to that of the base material. In a case, for example, where oxygen is introduced through projection of oxygen ions by an ion gun, the irradiation time with oxygen ions can be set, for example, to 5 to 60 seconds, the acceleration voltage of the ion gun can be set, for example, to 100 to 1000 V, and the current can be set, for example, to 100 to 600 mA.

### <Layers that can be arbitrarily provided>

The metal layer may be directly positioned on the surface of the lens base material, or may be indirectly positioned on the surface of the base material via one or more other layers. Examples of layers that can be formed between the base material and the metal layer include a polarizing layer, a photochromic layer and a hard coat layer. The durability (strength) of the optical product can be increased by providing a hard coat layer. The hard coat layer can be, for example, a cured layer obtained through curing of a curable composition. For example, paragraphs [0025] to [0028] and [0030] of Japanese Patent Application Publication No. 2012-128135 can be referred to concerning a cured layer that can function as a hard coat layer. For example, a curable composition containing a silane compound and metal oxide particles can be applied directly to the surface of the base material, or indirectly via another layer, to thereby form a coating layer; a cured layer can then be formed through curing of the coating layer by a curing treatment (for example, by heating or irradiation with light). A primer layer for improving adhesion may be formed between the metal layer and the base material. For example, paragraphs [0029] and [0030] of Japanese Patent Application Publication No. 2012-128135 can be referred to for details on the primer layer.

### (Metal oxide layer)

In one aspect, the spectacle lens can have a metal oxide layer (hereinafter also notated as "first metal oxide layer") between the metal layer and the base material. According to the invention, the spectacle lens has a metal oxide layer (hereinafter also notated to as "second metal oxide layer") on the surface of the surface layer portion-side of the metal layer, on the side opposite to that of the base material. In yet another aspect, the spectacle lens is an optical product having a metal oxide layer (first metal oxide layer) between the metal layer and the base material, and a metal oxide layer (second metal oxide layer) on the surface layer portion-side surface of the metal layer. In the present invention and the present description, the term "metal oxide layer" denotes a film formed through deposition of a metal oxide in accordance with an arbitrary film formation method, the film consisting of a metal oxide, except for impurities that become inevitably mixed in at the time of film formation and known additives that are used arbitrarily in order to assist film formation. The metal oxide layer can be a film in which a metal oxide takes up, for example, 90 to 100 mass%, and can be a film in which a metal oxide takes up 95 to 100 mass%, of the mass of the film. Examples of the metal oxide layer include a silicon oxide layer, an aluminum oxide layer, a cerium oxide layer, a chromium oxide layer, a molybdenum oxide layer, a tungsten oxide layer, a zirconium oxide layer, a titanium oxide layer, a niobium oxide layer, a tin oxide layer and a tantalum oxide layer.

The first metal oxide layer positioned between the metal oxide layer and the base material can be preferably a layer in direct contact with the metal layer, and more preferably a layer directly laid up on the surface of a cured layer that is provided on the base material. The first metal oxide layer is preferably a silicon oxide layer, from the viewpoint of improving the adhesion with the metal layer and/or the cured layer. The film thickness of the first metal oxide layer lies preferably in the range of 1 to 100 nm, and more preferably in the range of 1 to 50 nm, from the viewpoint of improving adhesion to adjacent layers and in terms of transmittance.

The second metal oxide layer positioned on the surface of the surface layer portion side of the metal layer, on the side opposite to that of the base material, can be preferably a layer in direct contact with the metal layer. The second metal oxide layer can play, for example, a role of protecting the metal layer and a role of improving the durability of the optical product. From the viewpoint of protecting the metal layer and improving the durability of the optical product, the second metal oxide layer is preferably a silicon oxide layer, an aluminum oxide layer, a cerium oxide layer, a chromium oxide layer, a molybdenum oxide layer, a tungsten oxide layer, a zirconium oxide layer, a titanium oxide layer, a niobium oxide layer, a tin oxide layer or a tantalum oxide layer, and is more preferably a silicon oxide layer. The film thickness of the second metal oxide layer is preferably in the range of 1 to 100 nm, more preferably in the range of 1 to 50 nm, from the viewpoint of protecting the metal layer, improving the durability of the optical product, and in terms of transmittance.

In the present invention and the present description, the "metal oxide" may be in a state of stoichiometric composition, or may be in a state of oxygen deficit or excess relative to the stoichiometric composition.

The above optical product may further include a layer other than the above layers, at an arbitrary position. Examples of such other layers include various layers such as a water-repellent or hydrophilic antifouling layers, antifogging layers and the like. Known techniques can be applied to in all of these layers.

In one aspect, a surface treatment can be performed on the surface on which film formation is to be carried out, prior to formation of one or more of the above-mentioned various layers. Examples of such surface treatment include surface cleaning, and specific examples include ion cleaning. The surface on which film formation is to be carried out can be cleaned through removal, by ion cleaning, of organic matter adhered to that surface. Ion cleaning is a treatment in which the surface under treatment is irradiated with ions by an ion gun (IG). Oxygen ions are preferred as the ions to be projected, from the viewpoint of cleanability. Surface cleaning may be performed using an inert gas such as argon (Ar) gas, xenon (Xe) gas or nitrogen (N₂) gas, or may be performed by irradiation with oxygen radicals or oxygen plasma.

Examples of optical product include various types of lenses such as spectacle lenses, telescope lenses, lenses of binoculars, microscope lenses, endoscope lenses, and imaging system lenses of various kinds of cameras, but only spectacle lenses being part of the claimed invention.

### [Examples]

The present invention will be further explained hereafter by way of Examples 2 and 3. However, the present invention is not limited to the implementations illustrated in Examples.

### [Example 1]

A curable composition (hard coat solution made by HOYA Corporation (product name: HC60S)) containing a silane compound and metal oxide particles was applied onto an object-side surface (convex surface) of a lens base material for spectacles produced out of a monomer for spectacle lenses (MR8 made by Mitsui Chemicals, Inc.), to form a coating layer that was subsequently cured by heating, to provide a hard coat layer (cured layer).

The surface of the hard coat layer was ion-cleaned with oxygen ions in a vacuum vapor deposition apparatus. Ion cleaning was performed by projecting oxygen ions using an ion gun at an acceleration voltage of 350 V, a current of 180 mA, an O₂ introduction flow rate of 10 sccm, an Ar introduction flow rate of 10 sccm, and a treatment time of 45 sec.

A silicon oxide layer (first metal oxide layer) was vapor-deposited next (Emi. current: 155 mA) on the surface of the hard coat layer after ion cleaning, and then a chromium layer was vapor-deposited (Emi. current: 38 mA) as a metal layer on the surface of the silicon oxide layer.

The surface of the chromium layer was irradiated with oxygen ions using an ion gun at an acceleration voltage of 200 V, a current of 150 mA, an O₂ introduction flow rate of 20 sccm, and a treatment time of 20 sec, to thereby oxidize and passivate the surface layer portion of the chromium layer.

Thereafter, a silicon oxide layer (second metal oxide layer) was further vapor-deposited (Emi. current: 155 mA) on the surface of the passivated surface layer portion.

As a result, a spectacle lens was obtained that had a silicon oxide layer (10 nm), a chromium layer (10 nm) with a passivated surface layer portion, and a silicon oxide layer (10 nm), in this order, on a base material having a hard coat layer. The film thickness values in parentheses above and the below-described film thickness are the film thickness of each layer, calculated on the basis of the film forming conditions.

### [Examples 2 and 3]

Spectacle lenses were obtained in accordance with the same method as in Example 1, but herein the vapor deposition time when forming the chromium layer was changed, to form the chromium layers having the film thickness given in Table 1.

The thickness of the surface layer portion passivated by oxidation performed in Examples 1 to 3 (thickness calculated from the above oxidation conditions) is 5 nm.

### [Comparative Example 1]

A spectacle lens was obtained in accordance with the same method as in Example 2, but herein the oxidation treatment (oxygen ion irradiation) of the surface layer portion of the chromium layer was not carried out.

### [Evaluation method]

### 1. Change in transmittance

The luminous transmittance (hereafter notated as "initial luminous transmittance") of the spectacle lenses of Examples 1 to 3 and Comparative Example 1 was measured.

The luminous transmittance of each spectacle lens was measured after the lens had been allowed to stand in air, at room temperature, for 1 day. The luminous transmittance measured herein is notated hereafter as "luminous transmittance after standing".

The rate of change of transmittance after standing was calculated on the basis of the expression below. Rate of change of transmittance after standing = ((luminous transmittance after standing - initial luminous transmittance)/initial luminous transmittance) × 100

Spectacle lenses different from the above spectacle lenses were prepared, for Examples 1 to 3 and Comparative Example 1; the luminous transmittance (initial luminous transmittance) was measured, and thereafter, the surface of the second metal oxide layer (silicon oxide layer) of each spectacle lens was subjected to a forced oxidation treatment by being irradiated with oxygen ions using an ion gun at an acceleration voltage of 200 V, a current of 150 mA, an O₂ introduction flow rate of 20 sccm, and a treatment time of 40 sec. The luminous transmittance of each spectacle lens after the above forced oxidation treatment was measured. The luminous transmittance measured here is referred to as "luminous transmittance after forced oxidation treatment" hereinafter.

The rate of change in transmittance after forced oxidation was calculated on the basis of the expression below. Rate of change in transmittance after forced oxidation = ((luminous transmittance after forced oxidation - initial luminous transmittance)/initial luminous transmittance) × 100

The above measurement of luminous transmittance was carried out in accordance with JIS T 7333:2005.

### 2. Wear resistance

The outermost surface of each spectacle lens of Examples 1 to 3, on the side opposite to that of the base material, was subjected to a 20-reciprocation wear test with steel wool (Bonstar #00000) under a load of 2.5 kg, using a reciprocating friction and wear tester by SHINTO Scientific Co., Ltd., and an evaluation was performed in accordance with the evaluation criteria below.

### (Evaluation criteria)

A: no scratches, or virtually no scratches, can be visually observed.
B: slight scratching observed.
C: clear scratching observed.

The results are given in Tables 1 and 2.

**[Table 1]**

| | Film thickness of metal layer (nm) | Passivation of surface layer portion | Rate of change of transmittance after standing (%) | Rate of change in transmittance after forced oxidation (%) |
|---|---|---|---|---|
| Example 1 | 10 | Carried out | 0.4 | 0.2 |
| Example 2 | 20 | Carried out | 0.4 | 0.2 |
| Example 3 | 30 | Carried out | 0.5 | 0.2 |
| Comp.Ex.1 | 20 | Not carried out | 1.5 | 1.3 |

**[Table 2]**

| | Wear resistance |
|---|---|
| Example 1 | B |
| Example 2 | A |
| Example 3 | A |

The results in Table 1 reveal that the spectacle lenses of Examples 1 to 3 afford greater suppression of change in transmittance over time (lower rate of change of transmittance after standing) than the spectacle lens of Comparative Example 1. The spectacle lenses of Examples 1 to 3 exhibited a lower rate of change of transmittance after forced oxidation than the spectacle lens of Comparative Example 1, and accordingly proved to be less susceptible to the influence of oxygen.

The results given in Table 2 reveal that the spectacle lenses of Examples 1 to 3 do not wear readily, and exhibit superior durability.

By contrast, the wear resistance of a spectacle lens produced in accordance with the same method as that of Example 2, except that the second metal oxide layer (silicon oxide layer) was not formed, yielded an evaluation result of C, when evaluated in accordance with the method above.

It should be noted that the embodiments disclosed herein are exemplary in all respects, and are not limiting in any way. The scope of the present invention is defined by the claims, not by the above explanation, and is meant to encompass all modifications within a meaning and scope of the claims.

### [Industrial Applicability]

One aspect of the present invention is useful in the field of manufacturing of various optical products such as spectacle lenses.

## Claims

1. A spectacle lens,
which comprises a metal layer on a base material,
wherein a surface layer portion of the metal layer on an opposite side thereof to a base material side thereof is a layer of a metal oxide resulting from oxidation of a metal included in the metal layer,
wherein the thickness of the metal layer is in the range of 15 to 30 nm and the spectacle lens has a metal oxide layer, which is a layer in direct contact with the metal layer and positioned on the surface of the surface layer portion side of the metal layer, on the side opposite to that of the base material.

2. The optical product according to claim 1,
wherein the metal layer is a chromium layer, a niobium layer, a titanium layer or an aluminum layer.

3. The optical product according to any of claims 1 to 2,
wherein a thickness of the surface layer portion is in a range of 1 to 30 nm.

4. The optical product according to any of claims 1 to 3,
which comprises a metal oxide layer between the metal layer and the base material.

5. The optical product according to claim 4,
wherein the metal oxide layer positioned between the metal layer and the base material is a silicon oxide layer.

6. The optical product according to claim 4 or 5,
wherein the metal oxide layer positioned on the surface layer portion-side surface of the metal layer is a silicon oxide layer.

7. A method of manufacturing an optical product,
wherein the optical product is the optical product according to any of claims 1 to 6, and
the method comprising:
forming a metal layer on a base material, and
passivating a surface layer portion of the formed metal layer by an oxidation treatment.

8. The method of manufacturing an optical product according to claim 7, which comprises performing the oxidation treatment by oxygen ion irradiation.

9. The method of manufacturing an optical product according to claim 8, wherein the oxygen ion irradiation is carried out with an ion gun.

## Patentansprüche

1. Brillenglas,
das eine Metallschicht auf einem Trägermaterial umfasst,
wobei ein Oberflächenschichtabschnitt der Metallschicht auf einer Seite, die einer Seite des Trägermaterials gegenüberliegt, eine Schicht aus einem Metalloxid ist, das durch Oxidation eines in der Metallschicht enthaltenen Metalls entsteht,
wobei die Dicke der Metallschicht im Bereich von 15 bis 30 nm liegt und das Brillenglas eine Metalloxidschicht aufweist, bei der es sich um eine Schicht handelt, die in direktem Kontakt mit der Metallschicht steht und auf der Oberfläche des Oberflächenschichtabschnitts auf der Seite der Metallschicht angeordnet ist, die der Seite des Trägermaterials gegenüberliegt.

2. Optisches Erzeugnis nach Anspruch 1,
wobei die Metallschicht eine Chromschicht, eine Niobschicht, eine Titanschicht oder eine Aluminiumschicht ist.

3. Optisches Erzeugnis nach einem der Ansprüche 1 bis 2,
wobei die Dicke des Oberflächenschichtabschnitts in einem Bereich von 1 bis 30 nm liegt.

4. Optisches Erzeugnis nach einem der Ansprüche 1 bis 3,
das eine Metalloxidschicht zwischen der Metallschicht und dem Trägermaterial umfasst.

5. Optisches Erzeugnis nach Anspruch 4,
wobei die zwischen der Metallschicht und dem Trägermaterial angeordnete Metalloxidschicht eine Siliziumoxidschicht ist.

6. Optisches Erzeugnis nach Anspruch 4 oder 5,
wobei die Metalloxidschicht, die sich auf der oberflächenschichtabschnittsseitigen Oberfläche der Metallschicht befindet, eine Siliziumoxidschicht ist.

7. Verfahren zur Herstellung eines optischen Erzeugnisses,
wobei das optische Erzeugnis das optische Erzeugnis nach einem der Ansprüche 1 bis 6 ist, und
das Verfahren umfasst:
Bildung einer Metallschicht auf einem Trägermaterial und
Passivierung eines Oberflächenschichtabschnitts der gebildeten Metallschicht durch eine
Oxidationsbehandlung.

8. Verfahren zur Herstellung eines optischen Erzeugnisses nach Anspruch 7, das die Durchführung der Oxidationsbehandlung durch Sauerstoffionenbestrahlung umfasst.

9. Verfahren zur Herstellung eines optischen Erzeugnisses nach Anspruch 8,
wobei die Sauerstoffionenbestrahlung mit einer Ionenkanone durchgeführt wird.

## Revendications

1. Un verre de lunettes,
qui comprend une couche métallique sur un matériau de base,
dans lequel une partie de la couche métallique située sur la face opposée au matériau de base est une couche d'oxyde métallique résultant de l'oxydation d'un métal inclus dans la couche métallique,
dans lequel l'épaisseur de la couche métallique est comprise entre 15 et 30 nm et le verre de lunettes possède une couche d'oxyde métallique, qui est une couche en contact direct avec la couche métallique et positionnée sur la surface de la portion de la couche métallique, du côté opposé à celui du matériau de base.

2. Le produit optique selon la revendication 1,
dans lequel la couche métallique est une couche de chrome, de niobium, de titane ou d'aluminium.

3. Le produit optique selon l'une des revendications 1 à 2,
dans lequel l'épaisseur de la partie de la couche de surface est comprise entre 1 et 30 nm.

4. Le produit optique selon l'une des revendications 1 à 3,
qui comprend une couche d'oxyde métallique entre la couche métallique et le matériau de base.

5. Le produit optique selon la revendication 4,
dans lequel la couche d'oxyde métallique placée entre la couche métallique et le matériau de base est une couche d'oxyde de silicium.

6. Le produit optique selon la revendication 4 ou 5,
dans lequel la couche d'oxyde métallique positionnée sur la surface de la partie de la couche de surface de la couche métallique est une couche d'oxyde de silicium.

7. Une méthode de fabrication d'un produit optique,
dans laquelle le produit optique est le produit optique selon l'une des revendications 1 à 6, et
la méthode comprend :
former une couche métallique sur un matériau de base, et
passivation d'une partie de la couche de surface de la couche métallique formée par un traitement d'oxydation.

8. La méthode de fabrication d'un produit optique selon la revendication 7, qui comprend effectuer le traitement d'oxydation par irradiation d'ions d'oxygène.

9. La méthode de fabrication d'un produit optique selon la revendication 8,
dans laquelle l'irradiation par ions oxygène est effectuée à l'aide d'un canon à ions.
